# EUROPÄISCHE PATENTSCHRIFT

(11) **EP 2 609 606 B1**
(45) Veröffentlichungstag und Bekanntmachung des Hinweises auf die Patenterteilung: **04.07.2018**
(21) Anmeldenummer: 11776082.7
(22) Anmeldetag: 24.08.2011
(51) Int. Cl.: H01H 1/58, H01H 13/50, H05K 3/30, H05K 3/34, H01H 11/00

(54) **ELEKTRISCHER SCHALTER**
ELECTRIC SWITCH
INTERRUPTEUR ÉLECTRIQUE

(30) Priorität: 27.08.2010 DE 102010035671
(43) Veröffentlichungstag der Anmeldung: 03.07.2013
(73) Patentinhaber: Marquardt Mechatronik GmbH, 78604 Rietheim-Weilheim (DE)
(72) Erfinder: MUELLER, Heinrich, 78628 Tuttlingen (DE); MEJERL, Thomas, 78628 Rottweil (DE)
(74) Vertreter: Otten, Roth, Dobler & Partner mbB Patentanwälte
(86) Internationale Anmeldenummer: PCT/EP2011/004238
(87) Internationale Veröffentlichungsnummer: WO 2012/025222

(56) Entgegenhaltungen:
- DE-A1- 3 728 664
- DE-A1- 4 342 149
- DE-A1-102005 044 373
- DE-A1-102007 025 040
- FR-A1- 2 342 549
- FR-A1- 2 593 017
- GB-A- 798 130
- US-A1- 2008 280 504
- US-B1- 6 272 000

## Beschreibung

Die Erfindung betrifft einen elektrischen Schalter nach dem Oberbegriff des Patentanspruchs 1.

Ein solcher elektrischer Schalter kann in Elektro- sowie Hausgeräten der sogenannten weißen Ware, wie Waschmaschinen, Geschirrspülmaschinen, Trockner o. dgl., eingesetzt sein. Beispielsweise dient der Schalter in diesen Geräten als Netz- und/oder Hauptschalter. Vor allem eignet sich der elektrische Schalter für Kundengeräte mit Leiterplatten, welche sich in geringem Abstand direkt hinter einer Bedienblende befinden, so dass der große Netz-Schalter ohne zusätzliche aufwendige Betätigungselemente direkt durch die Leiterplatte hindurch betätigt werden kann. Nützlich ist das insbesondere dann, wenn auf der Leiterplatte weitere Bauteile, beispielsweise weitere Schalter, LEDs und/oder andere Leuchten, Anschlussbuchsen, Potentiometer o. dgl., bestückt werden, welche ebenfalls nahe der Bedienblende angeordnet sein sollen.

Ein derartiger elektrischer Schalter ist beispielsweise aus der DE 42 02 214 A1 bekannt. Der Schalter besitzt ein Gehäuse, in dem sich ein Kontaktsystem befindet. Ein zur schaltenden Einwirkung auf das Kontaktsystem dienendes Betätigungsorgan ragt an einer Seite aus dem Gehäuse heraus. Desweiteren ragen elektrische Anschlüsse für das Kontaktsystem aus dem Gehäuse heraus.

Weiter ist aus der DE 10 2005 044 373 A1 ein Geräteschalter mit Leiterplattenanschlüssen bekannt, der zur Bestückung auf der der Bedienungsseite gegenüberliegenden Leiterplattenseite in der Art einer Hinterleiterplattenmontage geeignet ist. Bei diesem Schalter ragt das Betätigungsorgan an einer ersten Seite aus dem Gehäuse und der Anschluss ragt an der gegenüberliegenden zweiten Seite aus dem Gehäuse. Wenigstens einer der Anschlüsse, und zwar insbesondere sämtliche Anschlüsse, sind derart abgewinkelt, dass der Anschluss von der zweiten Seite bis in etwa zur ersten Seite reicht und/oder über die erste Seite hinausragt. In einfacher Art und Weise ist der Schalter derart an der Leiterplatte montierbar, dass die erste Seite des Gehäuses der einen Seite der Leiterplatte zugewandt ist. Der Anschluss ist an einem Durchbruch in einer Leiterplatte von der einen Seite, beispielsweise der Rückseite, zur anderen Seite, beispielsweise der Vorderseite, der Leiterplatte durchsteckbar. Dadurch ist der Anschluss als Lötanschluss an der anderen Seite, nämlich der Vorderseite, der Leiterplatte mit einem Lötauge verlötbar. Zweckmäßigerweise ist in der Leiterplatte eine zum Betätigungsorgan korrespondierende Bohrung befindlich, so dass das Betätigungsorgan von der anderen Seite der Leiterplatte betätigbar ist.

Die Montage des bekannten Schalters auf der Leiterplatte ist somit recht aufwendig. Außerdem besteht die Gefahr, dass der Schalter vor Abschluss des Lötvorgangs von der Leiterplatte fällt, so dass ein erhöhter Ausschuss auftritt.

Weiterhin sind in den Dokumenten FR 2 342 549 A1, FR 2 593 017 A1, US 6 272 000 B1 und US 2008/280504 A1 elektrische Bauteile beschrieben, bei denen der elektrische Anschluss verrastbar in einem Durchbruch in der Leiterplatte angeordnet ist. Schließlich zeigt das Dokument DE 10 2007 025 040 A1 einen elektrischen Schalter, bei dem der Anschluss an der Leiterplatte anliegend angeordnet ist.

Der Erfindung liegt die Aufgabe zugrunde, den Schalter derart weiterzuentwickeln, dass dessen Montage auf der Leiterplatte vereinfacht ist.

Insbesondere soll der Schalter sowohl automatisch als auch von Hand auf der Rückseite der Leiterplatte, also gegenüber der Betätigungsseite, bestückt werden können. Die Betätigung des Schalters erfolgt dann durch eine entsprechend große Bohrung in der Leiterplatte. Desweiteren soll der Schalter nach Bestückung so in der Leiterplatte befestigt sein, dass er vor und/oder während des Lötvorganges nicht herausfällt oder seinen Abstand relativ zur Leiterplatte ändern kann, um einen Spielausgleich zu schaffen. Schließlich soll die Befestigung auf der Leiterplatte nicht durch Mittel erfolgen, welche durch das heiße Lötbad beschädigt und/oder beeinflusst werden und/oder das Lötbad selber verunreinigen.

Diese Aufgabe wird bei einem gattungsgemäßen elektrischen Schalter durch die kennzeichnenden Merkmale des Anspruchs 1 gelöst.

Beim erfindungsgemäßen elektrischen Schalter weist der Anschluss eine Rastnase auf. Die Rastnase greift bei der Montage des Schalters an der Leiterplatte am Durchbruch der Leiterplatte verrastend ein. Insbesondere greift die Rastnase dabei derart ein, dass eine Kante der Rastnase am Rand des Durchbruchs auf der anderen Seite der Leiterplatte anliegt. Am Gehäuse, und zwar insbesondere an dessen erster Seite, ist eine Abstützung für den Anschluss angeordnet, derart dass die Abstützung den Anschluss bei der Montage des Schalters an der Leiterplatte abstützt. Ein Herausfallen des Schalters von der Leiterplatte ist folglich verhindert, womit Fehlbestückungen der Leiterplatte sowie diesbezüglicher Ausschuss vermieden sind. Weitere Ausgestaltungen der Erfindung sind Gegenstand der Unteransprüche.

In einer weiteren Ausgestaltung, die einfach und dennoch funktionssicher ist, kann die Rastnase fest am Anschluss angeordnet sein. Zweckmäßigerweise ist der Anschluss federnd ausgestaltet, derart dass die Rastnase bei Montage des Schalters aufgrund der Federwirkung des Anschlusses an der Leiterplatte im Durchbruch verrastet. Vorteilhafterweise können hier die Anschlussspitzen sehr dünn und zentrisch zum Leiterplattenloch ausgeführt werden, was das Einstecken des Schalters an der Leiterplatte erleichtert. In einer anderen Ausgestaltung besteht die Rastnase aus einer am Anschluss befindlichen, elastisch beweglichen Rast- und/oder Schnappfeder. Die als Rast- und/oder Schnappfeder ausgestaltete Rastnase verrastet bei Montage des Schalters an der Leiterplatte im Durchbruch. Dabei sollte darauf geachtet werden, dass die Rastfeder nicht zu steif ausgebildet ist, um die Fügekräfte für den Schalter auf der Leiterplatte nicht unnötig zu erhöhen.

Zum einfachen Fügen des Anschlusses in den Durchbruch an der Leiterplatte ist zweckmäßigerweise der Anschluss am Ende zu einer Spitze geformt. Alternativ oder auch ergänzend kann die Abstützung den Anschluss nach der Montage des Schalters, insbesondere verrastend, festhalten. Damit weist der Anschluss die erforderliche Flexibilität zum Fügen in den Durchbruch der Leiterplatte auf. Nach dem Bestücken des Schalters auf der Leiterplatte ist jedoch eine gewisse Festigkeit gegeben, womit Erschütterungen, Schwingungen o. dgl. im Gebrauch keinen negativen Einfluss für die elektrische Kontaktierung des Schalters zur Leiterplatte ausüben.

In einer weiteren Ausgestaltung kann am Gehäuse, und zwar insbesondere an dessen erster Seite, wenigstens eine elastische Feder aus Kunststoff angeformt sein, derart dass der Schalter nach der Montage unter einer in Richtung zur Leiterplatte wirkenden mechanischen Spannung gesetzt ist. Diese von der Kunststofffeder ausgeübte mechanische Spannung zieht den Anschluss gegen die Leiterplatte, und zwar insbesondere gegen deren andere Seite, zurück. Dadurch wird wiederum ein Andrücken der Rastnase an die Leiterplatte am Rand des Durchbruches bewirkt, womit die Güte der Befestigung des Schalters auf der Leiterplatte weiter gesteigert ist.

Für besonders bevorzugte Ausgestaltungen ist nachfolgendes festzustellen.

Die Anschlüsse des Schalters sind so geformt, dass sie jeweils in ein einfach herzustellendes rundes Loch der Leiterplatte gefügt werden können. Die Enden sind hierzu zu einer Spitze geformt. Sie weisen eine feste Rastnase auf, welche die Anschlüsse nach dem Fügen in der Leiterplatte verrasten. Die Flexibilität und Kraft, welche erforderlich ist, um die Anschlüsse an der Leiterplattenkante einzurasten, wird erzeugt durch die Eigenspannung der Anschlüsse, unterstützt durch eine Kunststofffeder, welche am Gehäuse angeformt ist. Bei diesem Konzept sind die Anschlussenden spitz ausgeformt und werden genau auf die Mitte des Leiterplattenloches positioniert, so dass ein Finden des Loches bei der Bestückung erleichtert wird. Außerdem können die Anschlüsse beim Fügevorgang ausweichen, über die Leiterplattenlochkante schnappen, und werden dann durch die ihnen eigene Federkraft, sowie beispielsweise unterstützt durch eine am Gehäuse angeformte Kunststofffeder, an der Leiterplatte verrastet.

Alternativ können in den als Lötpin ausgestalteten Anschlüssen integrierte Rastfedern die Verrastung in der Leiterplatte übernehmen. Die Rastnase an den Rastfedern verrasten die Anschlüsse nach dem Fügen in der Leiterplatte. Bei diesem Konzept sollen die Anschlüsse durch eine in den Lötpin integrierte Rastfeder in der Leiterplatte einrasten. Allerdings können dann die Anschlussspitzen nicht sehr dünn und zentrisch zum Leiterplattenloch ausgeführt werden. Außerdem ist hier die Rastfeder relativ steif, was die Fügekräfte etwas erhöht.

Desweiteren kann das Gehäuse des Schalters Aufnahmen in der Art von Abstützungen aufweisen, die die Anschlüsse so fassen, dass sie bestmöglich auf das Lochbild der Leiterplatte treffen. Außerdem können am Gehäuse Rastfedern integriert sein, welche die Anschlüsse verrasten und während des Eindrückens des Schalters in die Leiterplatte bei der Montage abstützen.

Am Gehäuse des Schalters können elastische Federn aus Kunststoff angeformt sein, welche dafür sorgen, dass der Schalter nach seiner Bestückung in die Leiterplatte unter eine leichte mechanische Spannung gesetzt wird. Diese Spannung sorgt dafür, dass die Anschlüsse gegen die Leiterplatte zurückgezogen werden und somit immer optimal an der Leiterplatte anliegen.

Die mit der Erfindung erzielten Vorteile bestehen insbesondere darin, dass der Schalter manuell und/oder automatisch in einfach herzustellende runde Lötaugen auf der Leiterplatte bestückt werden kann. Der Schalter muss während des Lötvorganges nicht durch Niederhalter in seiner Position auf der Leiterplatte fixiert werden, was bisher die Montage aufwendig macht. Außerdem ist keine lötbadseitige Abdeckung von Kunststoffverrastungen erforderlich.

Ausführungsbeispiele der Erfindung mit verschiedenen Weiterbildungen und Ausgestaltungen sind in den Zeichnungen dargestellt und werden im folgenden näher beschrieben. Es zeigen
- Fig. 1: einen in einer Leiterplatte montierten elektrischen Schalter entsprechend einer ersten Ausführung in perspektivischer Ansicht,
- Fig. 2: den Schalter aus Fig. 1, wobei die Leiterplatte entfernt ist,
- Fig. 3: den Anschluss des Schalters aus Fig. 2 in einer Detailansicht,
- Fig. 4: eine Spannfeder am Schalter aus Fig. 2 in einer Detailansicht,
- Fig. 5: eine Andruckfeder am Anschluss des Schalters aus Fig. 2 in einer Detailansicht,
- Fig. 6: einen in einer Leiterplatte montierten elektrischen Schalter entsprechend einer zweiten Ausführung in perspektivischer Ansicht,
- Fig. 7: den Schalter aus Fig. 6, wobei die Leiterplatte entfernt ist,
- Fig. 8: den Anschluss des Schalters aus Fig. 7 in einer Detailansicht,
- Fig. 9: eine Spannfeder am Schalter aus Fig. 7 in einer Detailansicht und
- Fig. 10: eine Andruckfeder am Anschluss des Schalters aus Fig. 7 in einer Detailansicht.

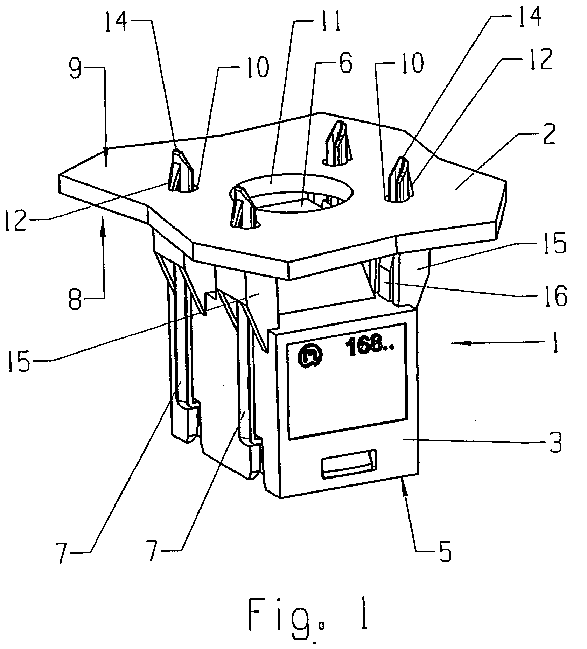

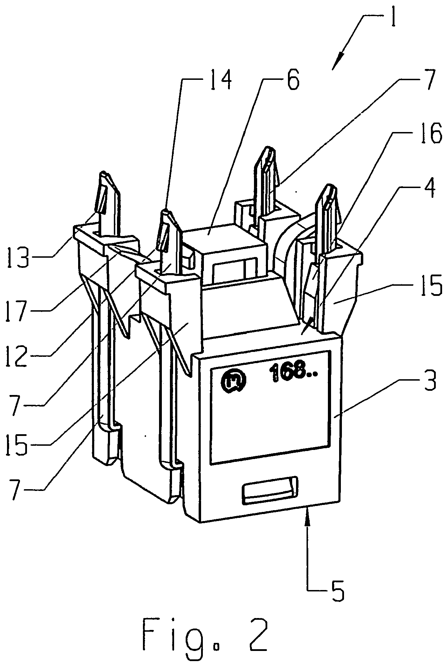

In Fig. 1 und Fig. 2 ist ein als Druckschalter zur Montage in Leiterplatten 2, beispielsweise durch Einlöten, ausgestalteter elektrischer Schalter 1 in perspektivischer Ansicht zu sehen. Dabei ist der Schalter 1 in Fig. 1 an der Leiterplatte 2 montiert, während in Fig. 2 der Schalter 1 an sich zu sehen ist. Der Schalter 1 weist ein Gehäuse 3 auf, in dem sich ein nicht weiter gezeigtes, an sich bekanntes Kontaktsystem befindet. An einer ersten Seite 4, und zwar der Oberseite, ragt ein Betätigungsorgan 6 zur schaltenden Einwirkung auf das Kontaktsystem aus dem Gehäuse 3 heraus. Im wesentlichen an der gegenüberliegenden zweiten Seite 5, und zwar an der Unterseite, ragen elektrische Anschlüsse 7 für das Kontaktsystem aus dem Gehäuse 3 heraus. Die Anschlüsse 7 sind derart abgewinkelt, dass die Anschlüsse 7 im wesentlichen von der zweiten Seite 5 bis in etwa zur ersten Seite 4 reichen bzw. über die erste Seite 4 hinausragen.

Der Schalter 1 ist gemäß der Fig. 1 an einer Leiterplatte 2 montierbar. Und zwar ist der Schalter 1 an der Rückseite 8 der Leiterplatte 2 montierbar, wobei die erste Seite 4 des Gehäuses 3 der Rückseite 8 der Leiterplatte 2 zugewandt ist Dies ist dadurch ermöglicht, indem der Anschluss 7 an einem Durchbruch 10 in der Leiterplatte 2 von der einen Seite 8, nämlich der Rückseite 8, zur anderen Seite 9, nämlich der Vorderseite 9, der Leiterplatte 2 durchsteckbar ist. Nachdem der Schalter 1 an der Leiterplatte 2 in der Weise bestückt ist, kann dann der Anschluss 7 als Lötanschluss in der Art eines Lötpins an der anderen Seite 9, nämlich der Vorderseite 9, der Leiterplatte 2 mit einem nicht weiter gezeigten Lötauge verlötet werden. Zur Betätigung des an der Leiterplatte 2 montierten Schalters 1 ist das Betätigungsorgan 6 über eine korrespondierende Bohrung 11 in der Leiterplatte 2 zugänglich und damit von der Vorderseite 9 der Leiterplatte 2 betätigbar.

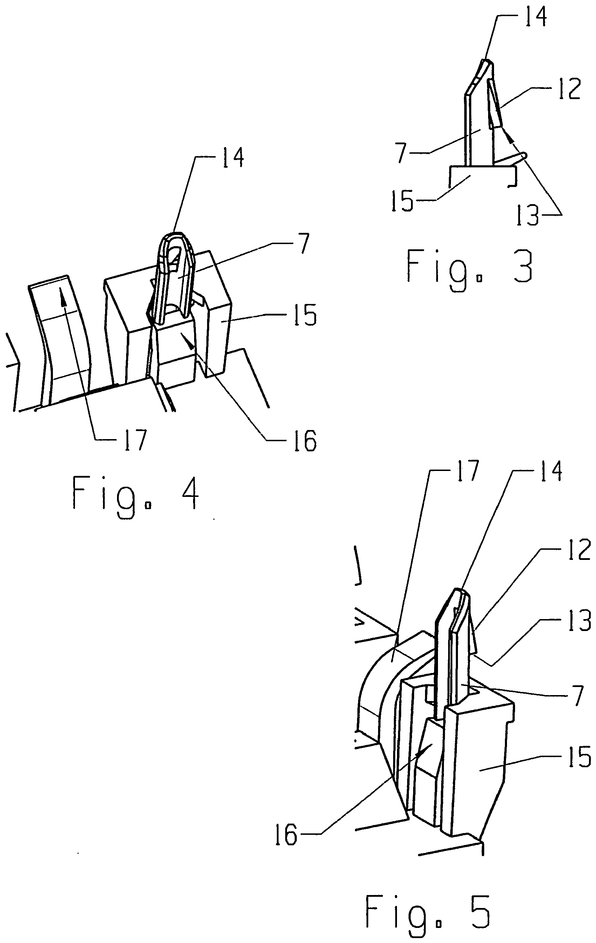

Der Anschluss 7 weist eine Rastnase 12 auf, wie man anhand der Fig. 3 sieht. Die Rastnase 12 greift gemäß Fig. 1 bei der Montage des Schalters 1 an der Leiterplatte 2 am Durchbruch 10 der Leiterplatte 2 verrastend ein. Und zwar insbesondere derart dass eine Kante 13 der Rastnase 12 (siehe hierzu Fig. 3) am Rand des Durchbruchs 10 auf der anderen Seite 9, also der Vorderseite, der Leiterplatte 2 anliegt. Der Schalter 1 ist somit nach dem Bestücken auf der Leiterplatte 2 mittels der Rastnase 12 zumindest solange fixiert bis das Verlöten erfolgt ist, womit vorteilhafterweise das Verlöten zeitlich vom Bestücken getrennt werden kann.

Wie man weiter anhand der Fig. 3 erkennt, besteht die Rastnase 12 aus einer am Anschluss 7 befindlichen, elastisch beweglichen Rast- und/oder Schnappfeder. Die Rast- und/oder Schnappfeder 12 bewegt sich aufgrund deren Elastizität beim Durchstecken durch den Durchbruch 10 wenigstens teilweise in den Anschluss 7 und kehrt nach Verlassen des Durchbruchs 10 aufgrund der elastischen Rückstellkraft wieder in deren Ausgangslage zurück. Dadurch verrastet dann die Rastnase 12 bei bzw. nach der Montage des Schalters 1 an der Leiterplatte 2 im Durchbruch 10 gemäß Fig. 1.

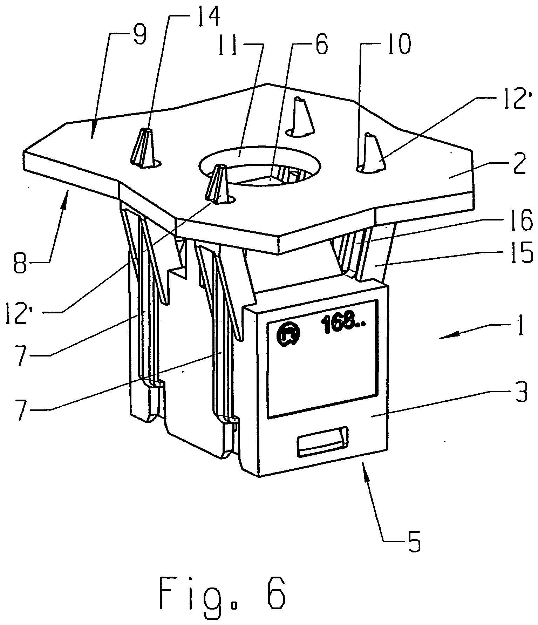

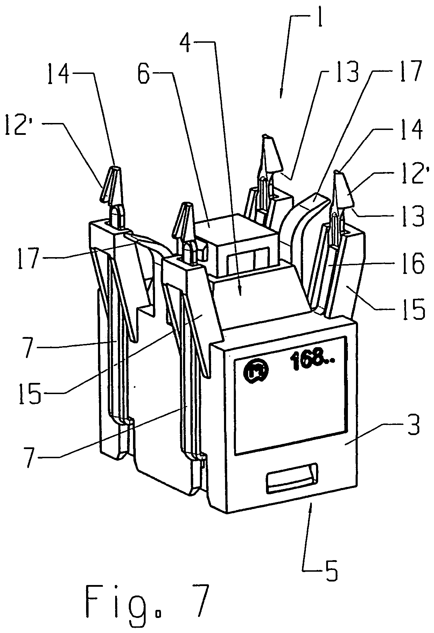

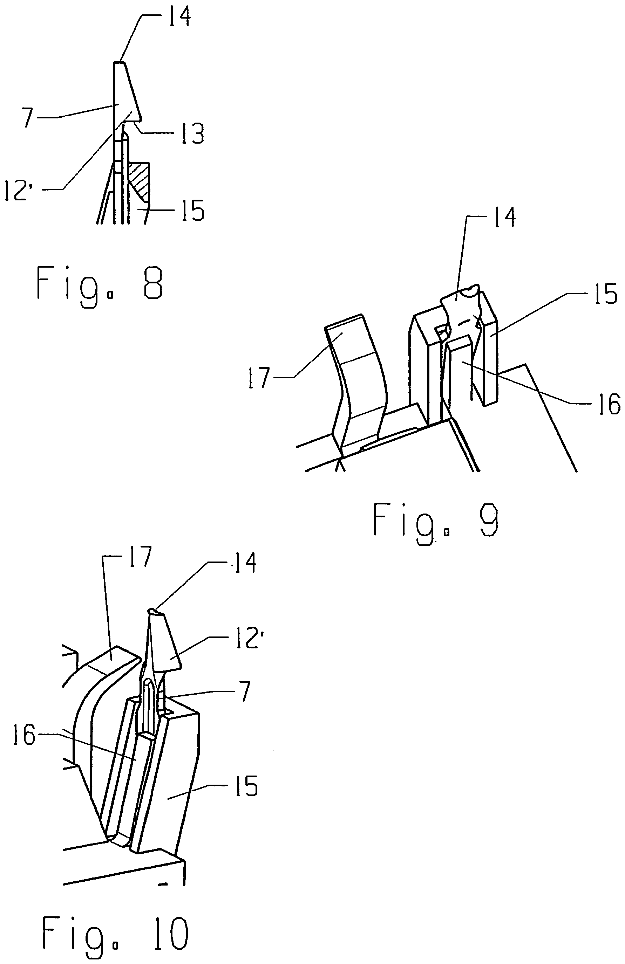

In einer zweiten Ausführung, die in den Fig. 6 bis Fig. 10 gezeigt ist, ist die Rastnase 12' fest am Anschluss 7 angeordnet. Wie anhand der Fig. 8 zu erkennen ist, ist die Rastnase 12' in der Art eines Rasthakens ausgestaltet Da der Rasthaken 12' starr am Anschluss 7 befindlich ist, ist wiederum der Anschluss 7 selbst federnd ausgestaltet. Dadurch kann die Rastnase 12' bei Montage des Schalters 1 aufgrund der Federwirkung des Anschlusses 7 beim Durchqueren des Durchbruches 10 ausweichen und anschließend nach Verlassen des Durchbruches 10 an der Vorderseite 9 der Leiterplatte 2 im Durchbruch 10 verrasten.

Wie man in Fig. 3 oder Fig. 8 sieht, ist der Anschluss 7 am Ende zu einer Spitze 14 geformt. Dadurch ist ein einfaches Fügen des Anschlusses 7 in den Durchbruch 10 an der Leiterplatte 2 ermöglicht. An der ersten Seite 4 des Gehäuses 3 des Schalters 1 ist eine in Fig. 5 sichtbare Abstützung 15 für den Anschluss 7 angeordnet, derart dass die Abstützung 15 den Anschluss 7 bei der Montage des Schalters 1 an der Leiterplatte 2 abstützt, womit Verformungen, Verbiegungen o. dgl. des Anschlusses 7 bei der Montage verhindert sind. Darüberhinaus kann die Abstützung 15 den Anschluss 7 nach der Montage des Schalters 1 zur Erhöhung der Stabilität festhalten, beispielsweise durch eine entsprechende Verrastung 16 des Anschlusses 7 an der Abstützung 15. Eine solche Verrastung 16 an der Abstützung 15 empfiehlt sich vor allem bei dem flexiblen Anschluss 7 der zweiten Ausführung, wo gemäß Fig. 10 der Anschluss 7 von der Abstützung 15 entgegen der Flexibilität des Anschlusses 7 festgehalten ist. Die Verrastung des Anschlusses 7 an der Abstützung 15 kann dabei durch eine am Gehäuse 3 befindliche Andruckfeder 16 bewirkt werden.

Wie anhand von Fig. 4 oder Fig. 9 zu erkennen ist, ist an der ersten Seite 4 des Gehäuses 3 weiterhin wenigstens eine elastische Feder 17 aus Kunststoff angeformt. Diese Feder 17 dient dazu, dass der Schalter 1 nach der Montage unter einer in Richtung zur Leiterplatte 2 wirkenden mechanischen Spannung gesetzt ist, welche gemäß Fig. 1 oder Fig. 6 den Anschluss 7 gegen die Leiterplatte 2, und zwar gegen deren Vorderseite 9, zurückzieht. Dadurch wird wiederum ein Andrücken der Rastnase 12, 12' an die Leiterplatte 2 am Rand des Durchbruches 10 bewirkt und eine sichere Fixierung des Schalters 1 an der Leiterplatte 2 gewährleistet. Außerdem bewirkt die Spannfeder 17 einen Spielausgleich des Schalters 1 zur Leiterplatte 2.

Die Erfindung ist nicht auf das beschriebene und dargestellte Ausführungsbeispiel beschränkt. Sie umfasst vielmehr auch alle fachmännischen Weiterbildungen im Rahmen der durch die Patentansprüche definierten Erfindung. So kann ein derartiger Schalter 1 nicht nur für Tastenfelder an Elektrogeräten, Haushaltsgeräten o. dgl. sondern auch als Bedienschalter für Kraftfahrzeuge, Werkzeugmaschinen o. dgl. Verwendung finden.

### Bezugszeichen-Liste:

- 1:: (elektrischer) Schalter
- 2:: Leiterplatte
- 3:: Gehäuse (von Schalter)
- 4:: erste Seite (von Gehäuse)
- 5:: zweite Seite (von Gehäuse)
- 6:: Betätigungsorgan
- 7:: (elektrischer) Anschluss
- 8:: eine Seite / Rückseite (der Leiterplatte)
- 9:: andere Seite / Vorderseite (der Leiterplatte)
- 10:: Durchbruch (in Leiterplatte)
- 11:: Bohrung (in Leiterplatte)
- 12:: Rastnase / Rast- und/oder Schnappfeder
- 12':: (feste) Rastnase / Rasthaken
- 13:: Kante (der Rastnase)
- 14:: Spitze (von Anschluss)
- 15:: Abstützung
- 16:: Andruckfeder / Verrastung (von Anschluss)
- 17:: Feder (am Gehäuse) / Spannfeder

## Patentansprüche

1. Elektrischer Schalter mit einer Leiterplatte und mit einem Gehäuse (3), mit einem im Gehäuse (3) befindlichen Kontaktsystem, mit einem an einer ersten Seite (4) aus dem Gehäuse (3) ragenden Betätigungsorgan (6) zur schaltenden Einwirkung auf das Kontaktsystem, und mit an der gegenüberliegenden zweiten Seite (5) aus dem Gehäuse (3) ragenden elektrischen Anschlüssen (7) für das Kontaktsystem, wobei der Schalter (1) derart an der Leiterplatte (2) montierbar ist, dass die erste Seite (4) des Gehäuses (3) der einen Seite (8) der Leiterplatte (2) zugewandt ist, wobei in der Leiterplatte (2) eine zum Betätigungsorgan (6) korrespondierende Bohrung (11) befindlich ist, derart dass das Betätigungsorgan (6) von der anderen Seite (9) der Leiterplatte (2) betätigbar ist, wobei der Anschluss (7) derart abgewinkelt ist, dass der Anschluss (7) im wesentlichen von der zweiten Seite (5) bis in etwa zur ersten Seite (4) reicht und/oder über die erste Seite (4) hinausragt sowie an einem Durchbruch (10) in der Leiterplatte (2) von der einen Seite (8) zur anderen Seite (9) der Leiterplatte (2) durchsteckbar ist, derart dass der Anschluss (7) als Lötanschluss an der anderen Seite (9) der Leiterplatte (2) mit einem Lötauge verlötbar ist, **dadurch gekennzeichnet, dass** der Anschluss (7) eine Rastnase (12, 12') aufweist, dass die Rastnase (12, 12') bei der Montage des Schalters (1) an der Leiterplatte (2) am Durchbruch (10) der Leiterplatte (2) verrastend eingreift, derart dass eine Kante (13) der Rastnase (12, 12') am Rand des Durchbruchs (10) auf der anderen Seite (9) der Leiterplatte (2) anliegt, und dass am Gehäuse (2) an dessen erster Seite (4) eine Abstützung (15) für den Anschluss (7) angeordnet ist, derart dass die Abstützung (15) den Anschluss (7) bei der Montage des Schalters (1) an der Leiterplatte (2) abstützt.

2. Elektrischer Schalter nach Anspruch 1, **dadurch gekennzeichnet, dass** die Rastnase (12') fest am Anschluss (7) angeordnet ist, und dass vorzugsweise der Anschluss (7) federnd ausgestaltet ist, derart dass die Rastnase (12') bei Montage des Schalters (1) aufgrund der Federwirkung des Anschlusses (7) an der Leiterplatte (2) im Durchbruch (10) verrastet.

3. Elektrischer Schalter nach Anspruch 1 oder 2, **dadurch gekennzeichnet, dass** die Rastnase (12) aus einer am Anschluss (7) befindlichen, elastisch beweglichen Rast- und/oder Schnappfeder besteht, derart dass die Rastnase (12) bei Montage des Schalters (1) an der Leiterplatte (2) im Durchbruch (10) verrastet.

4. Elektrischer Schalter nach Anspruch 1, 2 oder 3, **dadurch gekennzeichnet, dass** der Anschluss (7) am Ende zu einer Spitze (14) geformt ist.

5. Elektrischer Schalter nach einem der Ansprüche 1 bis 4, **dadurch gekennzeichnet, dass** die Abstützung (15) den Anschluss (7) nach der Montage des Schalters (1) mittels einer Verrastung (16) festhält.

6. Elektrischer Schalter nach einem der Ansprüche 1 bis 5, **dadurch gekennzeichnet, dass** am Gehäuse (3), insbesondere an dessen erster Seite (4), wenigstens eine elastische Feder (17) aus Kunststoff angeformt ist, derart dass der Schalter (1) nach der Montage unter einer in Richtung zur Leiterplatte (2) wirkenden mechanischen Spannung gesetzt ist, welche den Anschluss (7) gegen die Leiterplatte (2), insbesondere gegen deren andere Seite (9), zurückzieht.

## Claims

1. Electrical switch comprising a printed circuit board and comprising a housing (3), comprising a contact system which is located in the housing (3), comprising an operating element (6), which protrudes out of the housing (3) on a first side (4), for acting on the contact system in a switching manner, and comprising electrical connections (7), which protrude out of the housing (3) on the opposite second side (5), for the contact system, wherein the switch (1) can be mounted on the printed circuit board (2) in such a way that the first side (4) of the housing (3) faces one side (8) of the printed circuit board (2), wherein a bore (11) which corresponds to the operating element (6) is located in the printed circuit board (2) in such a way that the operating element (6) can be operated from the other side (9) of the printed circuit board (2), wherein the connection (7) is angled away in such a way that the connection (7) extends substantially from the second side (5) as far as approximately the first side (4) and/or protrudes beyond the first side (4) and also can be passed through an aperture (10) in the printed circuit board (2) from one side (8) to the other side (9) of the printed circuit board (2) in such a way that the connection (7), as a soldered connection, can be soldered to the other side (9) of the printed circuit board (2) by a soldering land, **characterized in that** the connection (7) has a latching lug (12, 12'), **in that**, when the switch (1) is mounted on the printed circuit board (2), the latching lug (12, 12') engages in a latching manner at the aperture (10) of the printed circuit board (2) in such a way that an edge (13) of the latching lug (12, 12') bears against the edge of the aperture (10) on the other side (9) of the printed circuit board (2), and **in that** a support (15) for the connection (7) is arranged on the first side (4) of the housing (2) in such a way that the support (15) supports the connection (7) when the switch (1) is mounted on the printed circuit board (2).

2. Electrical switch according to Claim 1, **characterized in that** the latching lug (12') is fixedly arranged on the connection (7), and **in that** the connection (7) is preferably of spring-action design in such a way that the latching lug (12') latches in the aperture (10) on account of the spring action of the connection (7) on the printed circuit board (2) when the switch (1) is mounted.

3. Electrical switch according to Claim 1 or 2, **characterized in that** the latching lug (12) consists of an elastically movable latching and/or snap-action spring which is located on the connection (7) in such a way that the latching lug (12) latches in the aperture (10) when the switch (1) is mounted on the printed circuit board (2).

4. Electrical switch according to Claim 1, 2 or 3, **characterized in that** the connection (7) is shaped at the end to form a spike (14).

5. Electrical switch according to one of Claims 1 to 4, **characterized in that** the support (15) fixedly holds the connection (7) by means of a latching arrangement (16) after the switch (1) has been mounted.

6. Electrical switch according to one of Claims 1 to 5, **characterized in that** at least one elastic spring (17) which is composed of plastic is integrally formed on the housing (3), in particular on the first side (4) of the said housing, in such a way that the switch (1), after being mounted, is subject to mechanical stress which acts in the direction of the printed circuit board (2) and pulls the connection (7) back towards the printed circuit board (2), in particular towards the other side (9) of the said printed circuit board.

## Revendications

1. Interrupteur électrique comportant une carte de circuit imprimé et un boîtier (3), un système de contact situé dans le boîtier (3), un organe d'actionnement (6) dépassant du boîtier (3) sur un premier côté (4) pour l'action de commutation sur le système de contact, et des bornes électriques (7) destinées au système de contact et dépassant du boîtier (3) sur le deuxième côté opposé (5), dans lequel l'interrupteur (1) peut être monté sur la carte de circuit imprimé (2) de manière à ce que le premier côté (4) du boîtier (3) soit tourné vers un côté (8) de la carte de circuit imprimé (2), dans lequel un alésage (11) correspondant à l'organe d'actionnement (6) est situé dans la carte de circuit imprimé (2) de manière à ce que l'organe d'actionnement (6) puisse être actionné depuis l'autre côté (9) de la carte de circuit imprimé (2), dans lequel la borne (7) est inclinée de manière à ce que la borne (7) s'étende sensiblement du deuxième côté (5) approximativement jusqu'au premier côté (4) et/ou dépasse du premier côté (4) et puisse être insérée à travers un passage (10) ménagé dans la carte de circuit imprimé (2) depuis un côté (8) jusqu'à l'autre côté (9) de la carte de circuit imprimé (2), de manière à pouvoir souder par un point de soudure la borne (7), en tant que borne soudée, sur l'autre côté (9) de la carte de circuit imprimé (2), **caractérisé en ce que** la borne (7) comporte un taquet d'arrêt (12, 12'), **en ce que** le taquet d'arrêt (12, 12'), lors du montage de l'interrupteur (1) sur la carte de circuit imprimé (2), s'engage par encliquetage dans le passage (10) de la carte de circuit imprimé (2), de manière à ce qu'une arête (13) du taquet d'arrêt (12, 12') porte contre le bord du passage (10) sur l'autre côté (9) de la carte de circuit imprimé (2) et **en ce qu'**un support (15) destiné à la borne (7) est disposé sur le boîtier (2), sur son premier côté (4), de manière à ce que le support (15) supporte la borne (7) lors du montage de l'interrupteur (1) sur la carte de circuit imprimé (2).

2. Interrupteur électrique selon la revendication 1, **caractérisé en ce que** le taquet d'arrêt (12') est disposé de manière fixe sur la borne (7), et **en ce que** la borne (7) est de préférence sollicitée par ressort de manière à ce que le taquet d'arrêt (12') s'engage par encliquetage dans le passage (10) lors du montage de l'interrupteur (1) du fait de l'effet de ressort de la borne (7) sur la carte de circuit imprimé (2).

3. Interrupteur électrique selon la revendication 1 ou 2, **caractérisé en ce que** le taquet d'arrêt (12) est constitué d'un ressort d'arrêt et/ou d'encliquetage mobile élastiquement situé sur la borne (7) de manière à ce que le taquet d'arrêt (12) s'engage par encliquetage dans le passage (10) lors du montage de l'interrupteur (1) sur la carte de circuit imprimé (2).

4. Interrupteur électrique selon la revendication 1, 2 ou 3, **caractérisé en ce que** la borne (7) est réalisée sous la forme d'une pointe (14) à son extrémité.

5. Interrupteur électrique selon l'une des revendications 1 à 4, **caractérisé en ce que** le support (15) maintient la borne (7) après le montage de l'interrupteur (1) au moyen d'un dispositif d'encliquetage (16).

6. Interrupteur électrique selon l'une des revendications 1 à 5, **caractérisé en ce qu'**au moins un ressort élastique (17) en matière plastique est formé sur le boîtier (3), en particulier sur son premier côté (4), de manière à ce qu'après le montage, l'interrupteur (1) soit soumis à une contrainte mécanique agissant dans la direction de la carte de circuit imprimé (2), qui ramène la borne (7) contre la carte de circuit imprimé (2), en particulier contre son autre côté (9).
